# EUROPÄISCHE PATENTSCHRIFT

(11) **EP 0 767 483 B1**
(45) Veröffentlichungstag und Bekanntmachung des Hinweises auf die Patenterteilung: **04.08.1999**
(21) Anmeldenummer: 96110337.1
(22) Anmeldetag: 27.06.1996
(51) Int. Cl.: H01J 37/34

(54) **Vorrichtung zum Beschichten von Substraten im Vakuum**
Device for coating substrates in vacuum
Dispositif de revêtement de substrats dans le vide

(30) Priorität: 06.10.1995 DE 19537212
(43) Veröffentlichungstag der Anmeldung: 09.04.1997
(73) Patentinhaber: Balzers und Leybold Deutschland Holding AG, 63450 Hanau (DE)
(72) Erfinder: Szczyrbowski, Joachim, Dr., 63775 Goldbach (DE); Teschner, Götz, 63571 Gelnhausen (DE)

(56) Entgegenhaltungen:
- EP-A- 0 502 242
- EP-A- 0 546 293

## Beschreibung

Die Erfindung betrifft eine Vorrichtung zum Beschichten von Substraten im Vakuum, bestehend aus einer Wechselstromquelle, die mit zwei in einer evakuierbaren Beschichtungskammer angeordneten Kathoden verbunden ist, die elektrisch mit Targets zusammenwirken, die zerstäubt werden, und deren zerstäubte Teilchen sich auf dem Substrat niederschlagen, wobei in die Beschichtungskammer ein Prozeßgas einbringbar ist, und zwischen der Wechselstromquelle und dem Kathodenpaar ein Netzwerk angeordnet ist, das als Filter wirkt und aus einem Transformator, Spulen und Kondensatoren gebildet ist.

Es ist bereits eine Zerstäubungseinrichtung zur Herstellung dünner Schichten bekannt (DD-A-252 205), bestehend aus einem Magnetsystem und mindestens zwei darüber angeordneten Elektroden aus dem zu zerstäubenden Material, wobei diese Elektroden elektrisch so gestaltet sind, daß sie wechselweise Kathode und Anode einer Gasentladung sind. Die Elektroden sind zu diesem Zwecke an eine sinusförmige Wechselspannung von vorzugsweise 50 Hz angeschlossen.

Diese bekannte Zerstäubungseinrichtung soll besonders für die Abscheidung dielektrischer Schichten durch reaktive Zerstäubung geeignet sein. Durch den Betrieb der Einrichtung mit etwa 50 Hz soll vermieden werden, daß es zur Flitterbildung an der Anode und im Falle von Metallbeschichtung zu elektrischen Kurzschlüssen (sogenannten Arcs) kommt.

Bei einer anderen bereits bekannten Vorrichtung zum Aufstäuben eines dünnen Films, ist die Geschwindigkeit des Niederbringens von Schichten unterschiedlicher Materialien regelbar (DE-A-39 12 572). Um zu extrem dünnen Schichtpaketen zu gelangen, sind mindestens zwei unterschiedliche Arten von kathodenseitig vorgesehenen Gegenelektroden angeordnet.

Weiterhin sind ein Verfahren und eine Vorrichtung bekannt (DE-A-41 06 770) zum reaktiven Beschichten eines Substrats mit einem elektrisch isolierenden Werkstoff, beispielsweise mit Siliziumdioxid (SiO₂), bestehend aus einer Wechselstromquelle, die mit in einer Beschichtungskammer angeordneten, Magnete einschließende Kathoden verbunden sind, die mit Targets zusammenwirken, wobei zwei erdfreie Ausgänge der Wechselstromquelle mit je einer ein Target tragenden Kathode verbunden sind, wobei beide Kathoden in der Beschichtungskammer nebeneinanderliegend in einem Plasmaraum vorgesehen sind und zum gegenüberliegenden Substrat jeweils etwa den gleichen räumlichen Abstand aufweisen. Der Effektivwert der Entladespannung wird dabei von einer über eine Leitung an die Kathode angeschlossenen Spannungseffektivwerterfassung gemessen und als Gleichspannung einem Regler über eine Leitung zugeführt, der über ein Regelventil den Reaktivgasfluß vom Behälter in die Verteilerleitung so steuert, daß die gemessene Spannung mit einer Sollspannung übereinstimmt.

Bekannt ist auch eine Vorrichtung zum Beschichten eines Substrats (EP-A-0 546 293), bei der die beiden Ausgänge der Sekundärwicklung eines mit einem Mittelfrequenzgenerator verbundenen Transformators jeweils an eine Kathode über zwei Versorgungsleitungen angeschlossen sind, wobei die erste und die zweite Versorgungsleitung über zwei parallele Zweigleitungen untereinander in Verbindung stehen und in die erste Zweigleitung ein Schwingkreis eingeschaltet ist und wobei jede der beiden Versorgungsleitungen jeweils sowohl über in das Gleichspannungspotential gegenüber Erde einstellendes erstes elektrisches Glied mit der Beschichtungskammer als auch über ein entsprechendes zweites elektrisches Glied mit der jeweiligen Anode verbunden sind, wobei die Verknüpfung zwischen der Spule und der in die erste Versorgungsleitung eingeschalteten Drossel mit der Kathode einer Gleichrichterdiode verbunden ist, während die Anode dieser Gleichrichterdiode unter Zwischenschaltung eines Widerstandes in die Verknüpfung zwischen dem Kondensator des Schwingkreises und der zweiten Versorgungsleitung angebunden ist, weshalb die beiden Kathoden mit einem frei wählbaren Leistungsverhältnis betreibbar sind.

Schließlich ist eine Vorrichtung zum reaktiven Beschichten eines Substrats (DE-A-41 36 655.7) bekannt, bei der eine elektrisch von der Vakuumkammer getrennte, als Magnetronkathode ausgebildete, aus zwei elektrisch voneinander getrennten Teilen bestehende Kathode, bei der der Targetgrundkörper mit Joch und Magneten als der eine Teil - unter Zwischenschaltung einer Kapazität - an den negativen Pol einer Gleichstrom-Spannungsversorgung und das Target als der andere Teil über eine Leitung und unter Zwischenschaltung einer Drossel und einem dieser parallel liegenden Widerstand an die Stromversorgung angeschlossen ist und wobei das Target über eine weitere Kapazität mit dem Pluspol der Stromversorgung und mit der Anode verbunden ist, die ihrerseits - unter Zwischenschaltung eines Widerstandes - auf Masse liegt, wobei in Reihe zur induktionsarmen Kapazität eine Induktivität in die Zweigleitung zum Widerstand und zur Drossel eingeschaltet ist und der Wert für den Widerstand typischerweise zwischen 2 kΩ und 10 kΩ liegt. Diese ältere Vorrichtung ist bereits so ausgebildet, daß sie die überwiegende Zahl er während eines Beschichtungsprozesses auftretenden Arcs unterdrückt und die Energie der Arcs absenkt und die Wiederzündung des Plasmas nach einem Arc verbessert.

Die Einsetzbarkeit eines Sputterverfahrens steht und fällt mit der Stabilität des Prozesses. D. h. die Anordnung muß über lange Zeiten (300 h) stabil und ohne Arcing die elektrischen Daten (Kathodenstrom, Leistung) und die optischen Daten der Schicht (Brechungsindex, Schichtdicke, Schichtdickenverteilung) garantieren.

Je größer die Länge einer Kathode wird, desto größer wird die benötigte Leistung und desto schwieriger wird es, die Stabilitätsforderungen zu erfüllen. Das hat den physikalischen Hintergrund, daß die Spannung von Druck, Gasart und der Beschaffenheit der Targetoberfläche bestimmt wird, während der Strom proportional der Länge steigt. Kleine Änderungen in der Beschaffenheit der Targetoberfläche bewirken kleine Spannungsänderungen, die aber multipliziert mit dem hohen Strom, der aus der großen Kathodenlänge resultiert, zu hohen Leistungsänderungen führen, die so weit gehen können, daß das Target örtlich aufschmelzen kann.

Besonders problematisch ist es, bei hohen Leistungen den Oxidationsgrad der abgeschiedenen Schicht zu halten. Diese Aufgabe resultiert daraus, daß für die Großflächenbeschichtung von Architekturglas u. a. Oxide abgeschieden werden, indem von einem metallischen Target mit einem Sauerstoff-Argon-Gemisch gesputtert wird, um eine bestimmte Oxidmodifikation zu erhalten. Diese Oxidmodifikation wird benötigt, um z. B. die Farbe des Schichtsystems oder die Korrosionsbeständigkeit einzustellen.

Wird bei konstanter Leistung der Sauerstoff-Anteil erhöht, so "kippt die Kathode in den Oxidmodus". Erhöht man den Sauerstoffanteil nur wenig über den "Kipp-Punkt" hinaus, so kann die Kathode wieder durch Erhöhen der Leistung in den Metallmodus zurückgeholt werden.

Es sind 2 grundsätzliche Verhaltensweisen der Kathoden bekannt:
- Typ 1:: Der Widerstand der Kathoden sinkt mit wachsendem Reaktivgasanteil.
- Typ 2:: Der Widerstand der Kathoden steigt mit wachsendem Reaktivgasanteil.

Welcher Typ vorliegt, hängt von dem Material und von der Reaktivgasart ab.

Die meisten Anwendungen benutzen als "Arbeitspunkt" ein Verhältnis von Sauerstoff-Anteil zur Leistung, das in der Nähe des "Kipp-Punktes" liegt. Das ist darin begründet, daß in diesem Bereich die höchsten Oxid-Beschichtungsraten erreicht werden. Für die Steuerung der Anlage ist dieser Arbeitspunkt sehr ungünstig, weil geringe Fluktuationen in Leistung, Sauerstoff oder Umgebung der Kathode dazu führen können, daß der Modus umschlägt und damit Ausschuß produziert wird.

Aufgrund des oben genannten Zusammenhangs, daß mit größer werdender Kathode die Leistungsfluktuationen stark wachsen, wird der Spielraum für den stabilen Betrieb der Kathoden immer kleiner, so daß ohne zusätzliche Mittel Großkathoden bei anspruchsvollen Materialien wie Si/SiO₂ technisch überhaupt nicht mehr betrieben werden können.

Ziel der Erfindung ist es, auch bei höchsten Leistungen mittels einer Selbststabilisierung ein zuverlässiges Arbeiten garantieren zu können.

Diese Aufgabe wird erfindungsgemäß dadurch gelöst, daß in die Beschichtungskammer ein Prozeßgas einbringbar ist, und zwischen der Wechselstromquelle und dem Kathodenpaar ein Netzwerk angeordnet ist, das als Filter wirkt und das aus einem Transformator und weiteren Spulen und Kondensatoren gebildet ist, und die Frequenz der Wechselstromquelle von jeder Eigenfrequenz des Filters abweicht und der Verlauf der Kathodenleistung als Funktion des Kathodenwiderstandes, den die Gasentladung für den Wechselstrom bildet, einen Maximalwert aufweist, wobei der Widerstand im Maximum so gewählt ist, daß der Kathodenwiderstand im Arbeitspunkt vom Widerstand im Maximum abweicht und die Impedanz des Netzwerkes dem Wechsel von einem Prozeßzustand in den anderen entgegenwirkt.

Weitere Merkmale und Einzelheiten sind in den abhängigen Unteransprüchen näher beschrieben und gekennzeichnet.

Die Erfindung läßt die verschiedensten Ausführungsmöglichkeiten zu; eine davon ist in den Zeichnungen näher dargestellt und zwar zeigen:

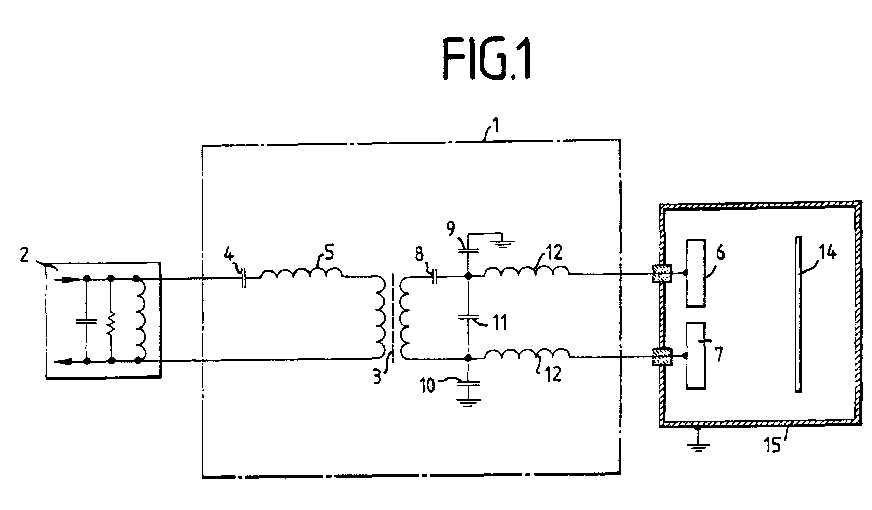

Figur 1 den Stromlaufplan der Stromversorgung für das Kathodenpaar und
Figur 2 das Diagramm für die Leistung über den Widerstand.

Dem Mittelfrequenz-Generator 2 wird die Energie an seinem Schwingkreis entnommen. Da dieser Schwingkreis bauartbedingt mit dem speisenden Netz in galvanischer Verbindung steht, muß ein Trenntrafo 3 in das Netzwerk 1 eingebaut werden. An welcher Stelle des Netzwerkes 1 der Transformator 3 eingefügt wird, ist für die weitere Betrachtung unwesentlich.

Im Ausführungsbeispiel wurden der Kondensator 4 und die Spule 5 auf der Schwingkreisseite des Transformators angeordnet und die restlichen Bauelemente auf der Seite der Kathoden 6, 7. Es wurde auch die Schaltung erfolgreich erprobt, bei der der Transformator 3 direkt an den Schwingkreis 2 angeschlossen und alle Kondensatoren und Spulen auf der Kathodenseite angeordnet wurden.

Der Kondensator 8 ist so groß gewählt, daß er auf den Frequenzgang der Schaltung wenig Einfluß hat. Er dient dazu, den Transformator 3 vor einem Gleichstrom zu schützen, der infolge von Differenzen in den Kennlinien der zwei Kathoden 6, 7 fließen und damit den Transformator 3 in seiner Funktion beeinträchtigen könnte.

Im Falle, daß der Transformator direkt an den Schwingkreis angeschlossen ist, kann der Kondensator 4 die Funktion von 8 übernehmen.

Die Kondensatoren 9 und 10 dienen der Funkentstörung, indem sie Ströme sehr hoher Frequenz gegen Erde ableiten. Diese sehr hochfrequenten Ströme können durch Schaltvorgänge im Plasma entstehen.

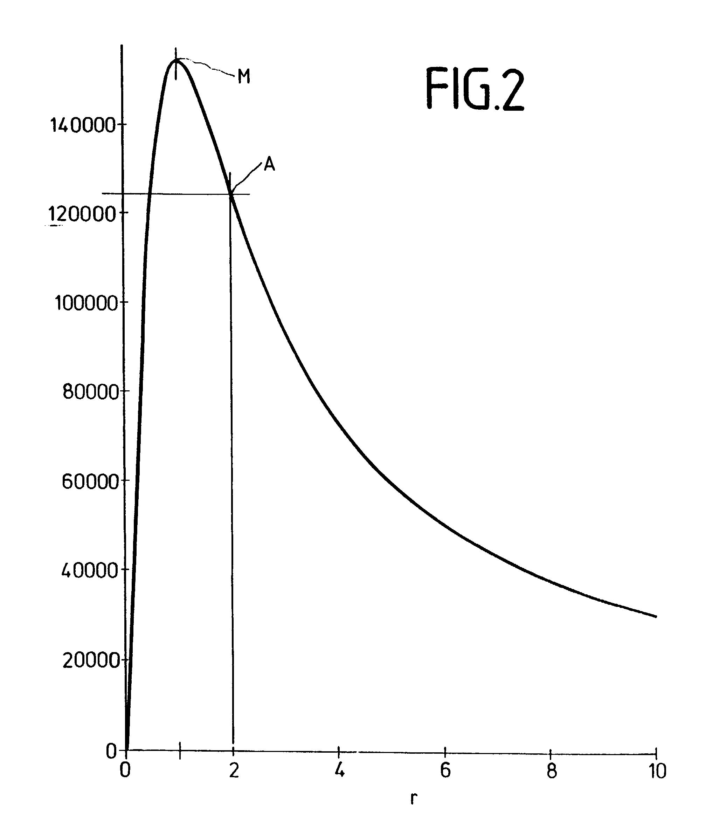

Die eigentliche Charakteristik, die die Selbststabilisierung ermöglicht, wird durch die Kondensatoren 4 und 11 sowie die Spulen 5 und 12 und 13 eingestellt. Formal können 12 und 13 zu einer Spule zusammengefaßt werden. Die Aufteilung in zwei gleich große Spulen 12 und 13 erfolgt, um einen möglichst symmetrischen Aufbau der gesamten Anordnung zu erhalten.
1. Bezugswert für die Berechnung ist der Ersatzwiderstand der Sputterstrecke xl, im folgenden Textteil mit r bezeichnet. Er wird gebildet als Quotient aus dem Effektivwert der Spannung zwischen den Kathoden 6, 7 bei der augenblicklichen Leistung und dem Effektivwert des Kathodenstromes bei Nennleistung, r = Ukat/Ikat.
2. Die Selbststabilisierung wird bei Kathoden mit Verhalten nach Typ 1 erreicht, wenn bei sinkendem Widerstand r die Leistung in den Kathoden 6, 7 steigt. Um genügenden Spielraum für die Stabilisierung im Produktionsprozeß bereitzuhalten, wählt man den Widerstandswert, bei dem das Maximum und damit das Ende der Selbststabilisierung erreicht wird, zu Rmax = 0,5 ... 0,75 ∗ r bei der gewünschten Nennleistung. Hierzu siehe Figur 2 mit Arbeitspunkt bei r.
3. Bei der Arbeitsfrequenz muß der Eingangswiderstand des Netzwerkes 1 von der Seite der Kathoden gemessen induktiv sein.
4. Der Eingangswiderstand Re des Netzwerkes 1 ist bei kleinen Frequenzen groß gegenüber Rmax, sinkt bis auf ein Minimum (1. Nullstelle) bei einer Frequenz unterhalb der Arbeitsfrequenz.
5. Bei der Arbeitsfrequenz erreicht der Betrag des Eingangswiderstandes Re den Wert 1,414 ∗ Rmax, d. h. der Imaginärteil und der Realteil des Eingangswiderstandes Re sind gleich Rmax.
6. Mit weiter steigender Frequenz steigt der Eingangswiderstand Re bis zu einem Maximum und fällt dann wieder ab auf ein 2. Minimum (2. Nullstelle). Die Frequenz dieser 2. Nullstelle ist etwa die dreifache Arbeitsfrequenz.

Praktische Werte für die Bauteile sind:
Arbeitsfrequenz: 40 kHz
C1 = 0,6 µF, C2 = 18 µF, C3 = 108 µF, C4 = 8 µF, C5 = 8 µF
L1 = 16 µH, L2 = L3 = 23 µH
Übersetzungsverhältnis des Transformators 1:2

## Patentansprüche

1. Vorrichtung zur Beschichtung von Substraten (14) im Vakuum, bestehend aus einer Wechselstromquelle (2), die mit zwei in einer evakuierbaren Beschichtungskammer (15) angeordneten Kathoden (6, 7) verbunden ist, die elektrisch mit Targets zusammenwirken, die in einer Gasentladung zerstäubt werden und deren zerstäubte Teilchen sich auf dem Substrat (14) niederschlagen, wobei in die Beschichtungskammer (15) ein Prozeßgas einbringbar ist, und zwischen der Wechselstromquelle (2) und dem Kathodenpaar (6, 7) ein Netzwerk (1) angeordnet ist, das als Filter wirkt, und das aus einem Transformator (3) und weiteren Spulen und Kondensatoren gebildet ist, und die Frequenz der Wechselstromquelle (2) von jeder Eigenfrequenz des Filters abweicht und der Verlauf der Kathodenleistung (P) als Funktion des Kathodenwiderstandes (r), den die Gasentladung für den Wechselstrom bildet, einen Maximalwert aufweist, wobei der Widerstand im Maximum so gewählt ist, daß der Kathodenwiderstand im Arbeitspunkt (A) vom Widerstand im Maximum (M) abweicht und die Impedanz des Netzwerkes (1) dem Wechsel von einem Prozeßzustand in den anderen entgegenwirkt.

2. Vorrichtung nach Anspruch 1, **dadurch gekennzeichnet,** daß der Widerstand im Leistungsmaximum (M) so gewählt ist, daß der Kathodenwiderstand im Arbeitspunkt (A) etwa zwei mal höher ist.

3. Vorrichtung nach den Ansprüchen 1 bis 2, **dadurch gekennzeichnet**, daß die von der Kathodenseite im Netzwerk (1) gemessene Impedanz induktiv ist.

4. Vorrichtung nach den Ansprüchen 1 bis 3, **dadurch gekennzeichnet,** daß der Kathodenwiderstand in allen Prozeßzuständen der Kathode (6, 7) größer bzw. kleiner als der Widerstand im Leistungsmaximum (M) ist.

## Claims

1. Device for coating substrates (14) in a vacuum, consisting of an alternating current source (2), which is connected to two cathodes (6, 7) disposed in an evacuatable coating chamber (15) and cooperating electrically with targets, which are atomised in a gas discharge and whose atomised particles are deposited on the substrate (14), wherein a process gas can be introduced into the coating chamber (15), and between the a.c. source (2) and the cathode pair (6, 7) a network (1) is disposed, which acts as a filter and which is formed of a transformer (3) and further coils and capacitors, and the frequency of the a.c. source (2) deviates from any inherent frequency of the filter and the curve of the cathode power (P) has as a function of the cathode resistance ( r ), which forms the gas discharge for the alternating current, a maximum value, wherein the resistance is so selected at a maximum that the cathode resistance at the operating point (A) deviates from the resistance at maximum (M) and the impedance of the network (1) counteracts the change from one processing state to the other.

2. Device according to claim 1, characterised in that the resistance at the power maximum (M) is so selected that the cathode resistance at the operating point (A) is approximately twice as high.

3. Device according to claims 1 to 2, characterised in that the impedance measured by the cathode side in the network (1) is inductive.

4. Device according to claims 1 to 3, characterised in that the cathode resistance in all processing states of the cathode (6, 7) is greater or smaller than the resistance at the power maximum (M).

## Revendications

1. Dispositif de revêtement de substrats (14) dans le vide, constitué par une source de courant alternatif (2) connectée à deux cathodes (6, 7) agencées dans une chambre de revêtement (15) susceptible d'être évacuée, qui coopèrent électriquement avec des cibles qui sont vaporisées dans une décharge gazeuse et dont les particules vaporisées se déposent sur le substrat (14), dans lequel un gaz réactionnel peut être introduit dans la chambre de revêtement (15), et entre la source de courant alternatif (2) et la paire de cathodes (6,7) est agencé un réseau (1) qui fait office de filtre et qui est formé par un transformateur (3), et en outre par des bobines et condensateurs, et la fréquence de la source de courant alternatif diffère de toute fréquence propre du filtre et le tracé de la puissance cathodique (P) présente une valeur maximale en tant que fonction de la résistance cathodique de polarisation (r) que forme la décharge gazeuse pour le courant alternatif, la résistance étant au maximum ainsi choisie que la résistance cathodique de polarisation diffère au point de travail (A) de la résistance au maximum (M), et l'impédance du réseau (1) s'oppose au changement d'un état de réaction à l'autre.

2. Dispositif selon la revendication 1, caractérisé en ce que la résistance au maximum de puissance (M) est ainsi choisie que la résistance cathodique de polarisation au point de travail (A) est approximativement deux fois plus élevée.

3. Dispositif selon les revendications 1 et 2, caractérisé en ce que l'impédance mesurée depuis le côté cathode dans le réseau (1) est inductive.

4. Dispositif selon les revendications 1 à 3, caractérisé la résistance cathodique de polarisation est plus grande ou plus petite que la résistance au maximum de puissance (M), dans tous les états de réaction des cathodes (6, 7).
